# EUROPEAN PATENT SPECIFICATION

(11) **EP 3 133 639 B1**
(45) Date of publication and mention of the grant of the patent: **26.06.2019**
(21) Application number: 15780524.3
(22) Date of filing: 07.04.2015
(51) Int. Cl.: H01L 21/304, B24B 37/00, C09K 3/14, H01L 21/321

(54) **COMPOSITION FOR POLISHING SILICON WAFERS**
ZUSAMMENSETZUNG ZUM POLIEREN VON SILICIUMWAFERN
COMPOSITION DE POLISSAGE DE TRANCHES DE SILICIUM

(30) Priority: 14.04.2014 JP 2014082951
(43) Date of publication of application: 22.02.2017
(73) Proprietor: Fujimi Incorporated, Nishikasugai-gun, Aichi 452-8502 (JP)
(72) Inventor: TSUCHIYA, Kohsuke, Kiyosu-shi Aichi 452-8502 (JP); TANSHO, Hisanori, Kiyosu-shi Aichi 452-8502 (JP); MORI, Yoshio, Kiyosu-shi Aichi 452-8502 (JP)
(74) Representative: Grünecker Patent- und Rechtsanwälte PartG mbB
(86) International application number: PCT/JP2015/001963
(87) International publication number: WO 2015/159507

(56) References cited:
- EP-A1- 2 075 824
- WO-A1-2007/055278
- WO-A1-2013/157554
- JP-A- 2008 091 524

## Description

### Technical Field

The present invention relates to a polishing composition used for polishing silicon wafers.

### Background Art

The surface of silicon wafers used as components in semiconductor products is commonly subjected to a lapping step (rough polishing step) and a polishing step (precision polishing step) to give a high-quality mirror surface. The polishing step typically includes a preliminary polishing step and a final polishing step. As the polishing method in the polishing step, chemical mechanical polishing using a polishing liquid containing a water-soluble polymer is known. By the method, adsorption and desorption of the water-soluble polymer to and from abrasive grains or silicon wafers contribute to a reduction in defects and haze of a polished surface. As a technical document on the composition for polishing silicon wafers, PTL 1 is exemplified. PTL 2 is a technical document on an abrasive used for polishing silicon dioxide.

### Citation List

### Patent Literature

PTL 1: JP 4772156 B
PTL 2: WO 2007/055278

### Summary of Invention

### Technical Problem

In recent years, semiconductor substrates such as silicon wafers and other substrates have been required to have higher-quality surfaces. Accordingly, there is a demand for a polishing composition capable of yielding substrate surfaces with lower haze. There is also a demand for a polishing composition having good filterability.

The present invention therefore has an object to provide a silicon wafer polishing composition that has excellent performances to reduce the haze of the surface of an object to be polished and has good filterability.

### Solution to Problem

According to the description, a composition for polishing silicon wafers used in a presence of abrasive grains is provided. A composition for polishing silicon wafers pertaining to an aspect of the present invention includes a silicon-wafer polishing accelerator, an amido group-containing polymer X, an organic compound Y having no amido group, and water. The amido group-containing polymer X has, on a main chain, a building block A derived from a monomer represented by General Formula (1). The amido group-containing polymer X having a molecular weight Mₓ of less than 5 × 10⁴. A relation between a molecular weight Mₓ of the amido group-containing polymer X and a molecular weight M_{y} of the organic compound Y satisfies an expression: 200 ≤ M_{y} < Mₓ. Such a composition for polishing silicon wafers can achieve both the performance of reducing the haze of the surface of silicon wafers and the filterability at higher levels.

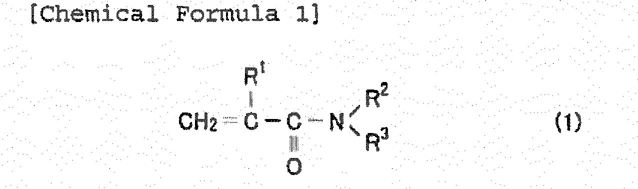

In General Formula (1), R¹ is a hydrogen atom; an alkyl group, an alkenyl group, an alkynyl group, an aralkyl group, an alkoxy group, an alkoxyalkyl group, or an alkylol group having a carbon number of 1 or more and 6 or less; an acetyl group; a phenyl group; a benzyl group; a chloro group; a difluoromethyl group; a trifluoromethyl group; or a cyano group. R² and R³ are the same or different and are independently a hydrogen atom; an alkyl group, an alkenyl group, an alkynyl group, an aralkyl group, an alkoxy group, an alkoxyalkyl group, an alkylol group, or an acetyl group having a carbon number of 1 or more and 18 or less; or an aromatic group having a carbon number of 6 or more and 60 or less, where the groups except the hydrogen atom optionally have a substituent, and R² and R³ are not simultaneously a hydrogen atom.

In the composition for polishing silicon wafers pertaining to the above aspect, a ratio of the molecular weight M_{y} of the organic compound Y to the molecular weight Mₓ of the amido group-containing polymer X (M_{y}/Mₓ) may be less than 0.5. According to such an aspect, the performance of reducing the haze of the surface of silicon wafers and the filterability can be simultaneously achieved at higher levels.

In the composition for polishing silicon wafers pertaining to the above aspect, the molecular weight Mₓ of the amido group-containing polymer X may be less than 5 × 10⁴. By using the composition for polishing silicon wafers including the amido group-containing polymer X having such a molecular weight Mₓ in combination with the organic compound Y, the performance of reducing the haze of the surface of silicon wafers and the filterability can be simultaneously achieved at higher levels.

In the composition for polishing silicon wafers pertaining to the aspect, the amido group-containing polymer X may be nonionic. By using the composition for polishing silicon wafers containing the nonionic amido group-containing polymer X, the haze reducing effect and the filterability improvement effect are more appropriately exerted.

In the composition for polishing silicon wafers pertaining to the aspect, R¹ in General Formula (1) may be a hydrogen atom or a methyl group. According to the composition for polishing silicon wafers containing the amido group-containing polymer X having such a structure, the haze reducing effect and the filterability improvement effect are more appropriately exerted.

In the composition for polishing silicon wafers pertaining to the aspect, R² and R³ in General Formula (1) are the same or different and may be independently a hydrogen atom or an alkyl group, an alkylol group, an alkoxyalkyl group, or an acetyl group having a carbon number of 1 or more and 3 or less (where R² and R³ are not simultaneously a hydrogen atom). According to the composition for polishing silicon wafers containing the amido group-containing polymer X having such a structure, the haze reducing effect and the filterability improvement effect are more appropriately exerted.

In the composition for polishing silicon wafers pertaining to the aspect, the abrasive grains may be silica particles. In the polishing using silica particles as the abrasive grains, the haze reducing effect and the filterability improvement effect by containing the amido group-containing polymer X and the organic compound Y in combination are more appropriately exerted.

### Description of Embodiments

An embodiment of the present invention will now be described. Matters not specifically mentioned in the description but required for carrying out the present invention can be understood as matters of design variation of a person skilled in the art based on related art in the field. The present invention can be carried out on the basis of the contents disclosed in the description and common general knowledge in the field.

### <Amido group-containing polymer X>

A composition for polishing silicon wafers disclosed here contains an amido group-containing polymer X having, on the main chain, a building block A derived from a monomer a represented by General Formula (1).

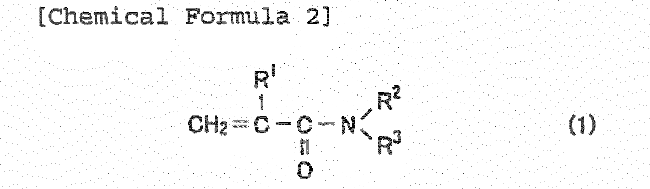

In General Formula (1), R¹ is a hydrogen atom; an alkyl group, an alkenyl group, an alkynyl group, an aralkyl group, an alkoxy group, an alkoxyalkyl group, or an alkylol group having a carbon number of 1 or more and 6 or less; an acetyl group; a phenyl group; a benzyl group; a chloro group; a difluoromethyl group; a trifluoromethyl group; or a cyano group. Of them, a hydrogen atom, an alkyl group having a carbon number of 1 or more and 6 or less, and a phenyl group are preferred, a hydrogen atom and an alkyl group having a carbon number of 1 or 2 are more preferred, and a hydrogen atom is specifically preferred.

R² and R³ are a group selected from a hydrogen atom, optionally substituted alkyl groups, alkenyl groups, alkynyl groups, aralkyl groups, alkoxy groups, alkoxyalkyl groups, alkylol groups, acetyl groups, and aromatic groups. The total carbon number of each of the optionally substituted alkyl groups, alkenyl groups, alkynyl groups, aralkyl groups, alkoxy groups, alkoxyalkyl groups, alkylol groups, and acetyl groups is 1 or more and 40 or less (preferably 1 or more and 24 or less, more preferably 1 or more and 14 or less, and even more preferably 1 or more and 10 or less) . The carbon number of each of the alkyl groups, alkenyl groups, alkynyl groups, aralkyl groups, alkoxy groups, alkoxyalkyl groups, alkylol groups, and acetyl group from which substituents are removed is 1 or more and 18 or less (preferably 1 or more and 8 or less, and more preferably 1 or more and 4 or less). The optionally substituted alkyl groups, alkenyl groups, alkynyl groups, aralkyl groups, alkoxy groups, alkoxyalkyl groups, alkylol groups, and acetyl groups may be a chain (linear or branched) group or a cyclic group, but are preferably a chain group. The aromatic group is an optionally substituted aryl group. The total carbon number of the aromatic group is 6 or more and 60 or less (preferably 6 or more and 36 or less, more preferably 6 or more and 24 or less, and even more preferably 6 or more and 12 or less).

The optional substituent of the alkyl groups, alkenyl groups, alkynyl groups, aralkyl groups, alkoxy groups, alkoxyalkyl groups, alkylol groups, acetyl group, and aromatic groups includes a hydroxy group, halogen atoms (for example, a chlorine atom), and a cyano group. The optional substituent of the alkyl groups, alkenyl groups, alkynyl groups, aralkyl groups, alkoxy groups, alkoxyalkyl groups, alkylol groups, and acetyl group includes the above-mentioned aromatic groups. The optional substituent of the aromatic groups further includes the above-mentioned alkyl groups, alkenyl groups, alkynyl groups, aralkyl groups, alkoxy groups, alkoxyalkyl groups, alkylol groups, and acetyl group.

Specifically, R² and R³ are preferably a hydrogen atom or an alkyl group having a carbon number of 1 or more and 18 or less (more preferably 1 or more and 8 or less (for example, 1 or more and 4 or less) and even more preferably 1 or more and 3 or less). The alkyl group may be a linear group or a branched group. R² and R³ are also preferably an alkoxy group, an alkoxyalkyl group, an alkylol group, or an acetyl group. The alkoxy group is preferably an alkoxy group having a carbon number of 1 or more and 8 or less (for example, 1 or more and 6 or less, typically 1 or more and 4 or less) (for example, a methoxy group). The alkoxyalkyl group is preferably an alkoxyalkyl group having a carbon number of 1 or more and 8 or less (for example, 1 or more and 6 or less, typically 1 or more and 4 or less) (for example, a methoxymethyl group, an ethoxymethyl group, a propoxymethyl group, or a butoxymethyl group). The alkylol group is preferably an alkylol group having a carbon number of 1 or more and 8 or less (for example, 1 or more and 6 or less, more preferably 1 or more and 3 or less, even more preferably 1 or 2) (for example, a methylol group, an ethylol group, or a propylol group). Of them, a methylol group or an ethylol group is preferred. R² and R³ may be the same or different, but R² and R³ are not simultaneously a hydrogen atom.

The monomer a disclosed here is exemplified by acrylamide derivatives such as N-monosubstituted acrylamides, N,N-disubstituted acrylamides, and α-substituted monomer of them (for example, N-monosubstituted methacrylamides and N,N-disubstituted methacrylamides).

Specific examples of the N-monosubstituted monomer include N-monoalkyl acrylamides such as N-methylacrylamide, N-ethylacrylamide, N-propylacrylamide, N-isopropylacrylamide, N-butylacrylamide, N-isobutylacrylamide, N-tert-butylacrylamide, N-heptylacrylamide, N-octylacrylamide, N-tert-octylacrylamide, N-dodecylacrylamide, and N-octadecylacrylamide; and substituted N-monoalkyl acrylamides such as N-(2-hydroxyethyl)acrylamide, N-(1,1-dimethyl-2-hydroxyethyl)acrylamide, N-(1-ethyl-hydroxyethyl)acrylamide, N-(2-chloroethyl)acrylamide, and N-(2,2,2-trichloro-1-hydroxyethyl)acrylamide.

Other specific examples of the N-monosubstituted monomer include N-monoalkenyl acrylamides such as N-allylacrylamide; N-monoalkynyl acrylamides such as N-(1,1-dimethylpropynyl)acrylamide; and aromatic group-containing acrylamides such as N-phenylacrylamide, N-benzylacrylamide, and N-[4-(phenylamino)phenyl]acrylamide.

Still other specific examples of the N-monosubstituted monomer include N-monoalkylol acrylamides such as N-methylolacrylamide, N-ethylolacrylamide, and N-propylolacrylamide; N-alkoxyalkyl acrylamides such as N-methoxymethylacrylamide, N-ethoxymethylacrylamide, N-butoxymethylacrylamide, and N-isobutoxymethylacrylamide; and N-alkoxy acrylamides such as N-methoxyacrylamide, N-ethoxyacrylamide, N-propoxyacrylamide, and N-butoxyacrylamide.

Still other specific examples of the N-monosubstituted monomer include N-acetylacrylamide and N-diacetone acrylamide.

Still other specific examples of the N-monosubstituted monomer include N-monoalkyl methacrylamides such as N-methylmethacrylamide, N-ethylmethacrylamide, N-propylmethacrylamide, N-isopropylmethacrylamide, N-butylmethacrylamide, N-isobutylmethacrylamide, N-tert-butylmethacrylamide, N-heptylmethacrylamide, N-octylmethacrylamide, N-tert-octylmethacrylamide, N-dodecylmethacrylamide, and N-octadecylmethacrylamide; and substituted N-monoalkyl methacrylamides such as N-(2-hydroxyethyl)methacrylamide, N-(1,1-dimethyl-2-hydroxyethyl)methacrylamide, N-(1-ethyl-hydroxyethyl)methacrylamide, N-(2-chloroethyl)methacrylamide, and N-(2,2,2-trichloro-1-hydroxyethyl)methacrylamide.

Still other specific examples of the N-monosubstituted monomer include N-monoalkenyl methacrylamides such as N-allylmethacrylamide; N-monoalkynyl methacrylamides such as N-(1,1-dimethylpropynyl)methacrylamide; and aromatic group-containing methacrylamides such as N-phenylmethacrylamide, N-benzylmethacrylamide, and N-[4-(phenylamino)phenyl]methacrylamide.

Still other specific examples of the N-monosubstituted monomer include N-monoalkylol methacrylamides such as N-methylolmethacrylamide, N-ethylolmethacrylamide, and N-propylolmethacrylamide; N-alkoxyalkyl methacrylamides such as N-methoxymethylmethacrylamide, N-ethoxymethylmethacrylamide, N-butoxymethylmethacrylamide, and N-isobutoxymethylmethacrylamide; and N-alkoxy methacrylamides such as N-methoxymethacrylamide, N-ethoxymethacrylamide, N-propoxymethacrylamide, and N-butoxymethacrylamide.

Still other specific examples of the N-monosubstituted monomer include N-acetylmethacrylamide and N-diacetone methacrylamide.

Of them, N-monosubstituted monomers having an alkylol group, such as N-(2-hydroxyethyl)acrylamide, N-(1,1-dimethyl-2-hydroxyethyl)acrylamide, N-(1-ethyl-hydroxyethyl)acrylamide, N-(2-hydroxyethyl)methacrylamide, N-(1,1-dimethyl-2-hydroxyethyl)methacrylamide, and N-(1-ethyl-hydroxyethyl)methacrylamide are preferred.

Specific examples of the N,N-disubstituted monomer include N,N-dialkyl acrylamides such as N,N-dimethylacrylamide, N,N-diethylacrylamide, N,N-dipropylacrylamide, N,N-diisopropylacrylamide, N,N-dibutylacrylamide, N,N-diisobutylacrylamide, N,N-di-tert-butylacrylamide, N,N-diheptylacrylamide, N,N-dioctylacrylamide, N,N-di-tert-octylacrylamide, N,N-didodecylacrylamide, and N,N-dioctadecylacrylamide; and substituted N,N-dialkyl acrylamides such as N,N-bis(2-hydroxyethyl)acrylamide and N,N-bis(2-cyanoethyl)acrylamide.

Other specific examples of the N,N-disubstituted monomer include N,N-dialkenyl acrylamides such as N,N-diallylacrylamide; aromatic group-containing acrylamides such as N,N-diphenylacrylamide and N,N-dibenzylacrylamide; and N,N-dialkylol acrylamides such as N,N-dimethylolacrylamide, N,N-diethylolacrylamide, and N,N-dipropylolacrylamide.

Still other specific examples of the N,N-disubstituted monomer include N-alkoxy-N-alkyl acrylamides such as N-methyl-N-methoxyacrylamide, N-methyl-N-ethoxyacrylamide, N-methyl-N-propoxyacrylamide, N-methyl-N-butoxyacrylamide, N-ethyl-N-methoxyacrylamide, N-ethyl-N-ethoxyacrylamide, N-ethyl-N-butoxyacrylamide, N-propyl-N-methoxyacrylamide, N-propyl-N-ethoxyacrylamide, N-butyl-N-methoxyacrylamide, and N-butyl-N-ethoxyacrylamide.

Still other specific examples of the N,N-disubstituted monomer include N,N-diacetylacrylamide and N,N-diacetone acrylamide.

Still other specific examples of the N,N-disubstituted monomer include N,N-dialkyl methacrylamides such as N,N-dimethylmethacrylamide, N,N-diethylmethacrylamide, N,N-dipropylmethacrylamide, N,N-diisopropylmethacrylamide, N,N-dibutylmethacrylamide, N,N-diisobutylmethacrylamide, N,N-di-tert-butylmethacrylamide, N,N-diheptylmethacrylamide, N,N-dioctylmethacrylamide, N,N-di-tert-octylmethacrylamide, N,N-didodecylmethacrylamide, and N,N-dioctadecylmethacrylamide; and substituted N,N-dialkyl methacrylamides such as N,N-bis(2-hydroxyethyl)methacrylamide and N,N-bis(2-cyanoethyl)methacrylamide.

Still other specific examples of the N,N-disubstituted monomer include N-dialkenyl methacrylamides such as N,N-diallylmethacrylamide; aromatic group-containing methacrylamides such as N,N-diphenylmethacrylamide and N,N-dibenzylmethacrylamide; and N,N-dialkylol methacrylamides such as N,N-dimethylol methacrylamide, N,N-diethylol methacrylamide, and N,N-dipropylol methacrylamide.

Still other specific examples of the N,N-disubstituted monomer include N-alkoxy-N-alkyl methacrylamides such as N-methyl-N-methoxymethacrylamide, N-methyl-N-ethoxymethacrylamide, N-methyl-N-propoxymethacrylamide, N-methyl-N-butoxymethacrylamide, N-ethyl-N-methoxymethacrylamide, N-ethyl-N-ethoxymethacrylamide, N-ethyl-N-butoxymethacrylamide, N-propyl-N-methoxymethacrylamide, N-propyl-N-ethoxymethacrylamide, N-butyl-N-methoxymethacrylamide, and N-butyl-N-ethoxymethacrylamide.

Still other specific examples of the N,N-disubstituted monomer include N,N-diacetylmethacrylamide and N,N-diacetone methacrylamide.

The above-mentioned monomers a can be used singly or in combination of two or more of them.

The amido group-containing polymer X is preferably nonionic. In other words, a polymer substantially containing no anionic building block or no cationic building block is preferred. Here, the substantially containing no anionic building block or no cationic building block means that the molar proportion of such a building block is less than 0.02% (for example, less than 0.001%). By using the composition for polishing silicon wafers containing the nonionic amido group-containing polymer, the effect of reducing defects and haze is appropriately exerted. Although the reason is not necessarily revealed, it can be supposed that the nonionic amido group-containing polymer X appropriately adsorbs to abrasive grains and silicon wafers at the time of polishing and thus contributes to a reduction of haze. It can also be supposed that the appropriate adsorption suitably prevents abrasive grains and polishing waste in a cleaning step from remaining and contributes to a reduction of defects.

The amido group-containing polymer X has a molecular weight that is larger than the molecular weight of the organic compound Y described later. The molecular less than 5 × 10⁴ and, for example, 3 × 10⁴ or less. The molecular weight of the amido group-containing polymer X is typically 5 × 10³ or more, and is preferably 1 × 10⁴ or more and more preferably 1.5 × 10⁴ or more from the viewpoint of haze reduction, for example. As the molecular weight of the amido group-containing polymer X, a weight average molecular weight (Mw) determined by GPC can be adopted.

The relation between the weight average molecular weight Mw and the number average molecular weight Mn of the amido group-containing polymer X is not limited to particular values. For example, a polymer having a molecular weight distribution (Mw/Mn) of 5.0 or less is preferably used from the viewpoint of suppressing the generation of agglomerates, for example. The Mw/Mn of the amido group-containing polymer X is preferably 4.0 or less, more preferably 3.5 or less, and even more preferably 3.0 or less (for example, 2.5 or less) from the viewpoint of performance stability of the composition for polishing silicon wafers, for example. In principle, the Mw/Mn is 1.0 or more. Commonly, an amido group-containing polymer X having an Mw/Mn of 1.05 or more is preferably used from the viewpoint of easy availability of raw materials and synthetic easiness.

As the Mw and Mn of amido group-containing polymers X, values determined by aqueous gel permeation chromatography (GPC) (aqueous system, in terms of polyethylene glycol) can be adopted.

The amido group-containing polymer X disclosed here is preferably composed of substantially only the building block A. In other words, in the amido group-containing polymer X, the proportion of the mole number of the building block A relative to the mole number of all building blocks contained in the molecular structure of the polymer (molar proportion) is preferably 99% by mole or more (for example, 99.9% by mole or more, typically 99.9 to 100% by mole) . Preferred examples of such a polymer include homopolymers containing a single type of the monomer a disclosed here and copolymers containing two or more types of the monomer a.

The amido group-containing polymer X disclosed here may be a copolymer containing a building block derived from one or more types of a monomer b that is copolymerizable with the monomer a (hereinafter also called "building block B") to such an extent as not to greatly impair effects of the invention. The building block B is defined as a different building block from the building block A. The building block B can be a building block containing no secondary amido group or no tertiary amido group. In the amido group-containing polymer X, the proportion (molar proportion) of the building block B can be less than 50% by mole (for example, less than 30% by mole, typically less than 10% by mole).

The "% by mole" is a molar proportion calculated where a single building block derived from a single monomer (including the monomer a and the monomer b) is regarded as one molecule. Hence, the proportions of the building blocks A and B can correspond to the molar proportions of the monomer a and the monomer b, respectively, in all the monomer components used for polymerization.

### <Organic compound Y>

The composition for polishing silicon wafers disclosed here includes, in addition to the amido group-containing polymer X, an organic compound Y having no amido group. The organic compound Y typically, preferably has a molecular weight (M_{y}) of 200 or more. It is also preferred to use an organic compound having a carbon number of 5 or more (preferably 6 or more, more preferably 10 or more). Any organic compound Y satisfying such conditions can be used without any limitation. An example of such an organic compound Y includes a surfactant having no amido group or a water-soluble polymer having no amido group.

As the surfactant having no amido group, an anionic surfactant or a nonionic surfactant can be preferably adopted. From the viewpoint of low foaming properties and easy adjustment of pH, a nonionic surfactant is more preferred. Examples of the nonionic surfactant include oxyalkylene polymers such as polyethylene glycol, polypropylene glycol, and polytetramethylene glycol; polyoxyalkylene adducts such as polyoxyethylene alkyl ethers, polyoxyethylene alkyl phenyl ethers, polyoxyethylene alkylamines, polyoxyethylene fatty acid esters, polyoxyethylene glyceryl ether fatty acid esters, and polyoxyethylene sorbitan fatty acid esters; and copolymers (diblock copolymers, triblock copolymers, random copolymers, alternating copolymers) of a plurality types of oxyalkylenes.

Specific examples of the nonionic surfactant include block copolymers of ethylene oxide (EO) and propylene oxide (PO) (diblock copolymers, polyethylene oxide (PEO)-polypropylene oxide (PPO)-PEO-type triblock copolymers, PPO-PEO-PPO-type triblock copolymers, for example), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octylphenyl ether, polyoxyethylene nonylphenyl ether, polyoxyethylene dodecyl phenyl ether, polyoxyethylene styrenated phenyl ether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbitol tetraoleate, polyoxyethylene castor oil, and polyoxyethylene hydrogenated castor oil.

As preferred nonionic surfactants of them, block copolymers of EO and PO (especially, PEO-PPO-PEO-type triblock copolymers), random copolymers of EO and PO, and polyoxyethylene alkyl ethers (for example, polyoxyethylene decyl ether) are exemplified.

The water-soluble polymer containing no amido group (hereinafter also called "optional polymer") can be a polymer having, in the molecule, at least one functional group selected from cationic groups, anionic groups, and nonionic groups. For example, the optional polymer can be a polymer having, in the molecule, a hydroxy group, a carboxyl group, an acyloxy group, a sulfo group, a quaternary ammonium structure, a heterocyclic structure, a vinyl structure, a polyoxyalkylene structure, or the like. A nonionic polymer is preferably adopted as the optional polymer from the viewpoint of reducing agglomerates or improving cleanability, for example.

Preferred examples of the optional polymer in the composition for polishing silicon wafers disclosed here include polymers containing an oxyalkylene unit, polymers containing a nitrogen atom, and vinyl alcohol polymers.

Examples of the polymer containing an oxyalkylene unit include PEO, block copolymers of EO and PO, and random copolymers of EO and PO. The block copolymer of EO and PO can be diblock copolymers and triblock copolymers containing a PEO block and a PPO block, for example. Examples of the triblock copolymer include PEO-PPO-PEO-type triblock copolymers and PPO-PEO-PPO-type triblock copolymers. Commonly, a PEO-PPO-PEO-type triblock copolymer is more preferred.

In block copolymers or random copolymers of EO and PO, the molar proportion of EO and PO (EO/PO) constituting the copolymer is preferably more than 1, more preferably 2 or more, and even more preferably 3 or more (for example, 5 or more) from the viewpoint of solubility in water and cleanability, for example.

As the polymer containing a nitrogen atom, either a polymer containing a nitrogen atom on the main chain or a polymer having a nitrogen atom on a side chain functional group (pendant group) can be used. Examples of the polymer containing a nitrogen atom on the main chain include homopolymers and copolymers of an N-acyl alkyleneimine type monomer. Specific examples of the N-acyl alkyleneimine type monomer include N-acetylethyleneimine and N-propionylethyleneimine. Examples of the polymer having a nitrogen atom on a pendant group include polymers containing an N-vinyl type monomer unit. For example, homopolymers and copolymers of N-vinylpyrrolidone can be adopted.

The vinyl alcohol polymer is typically a polymer containing a vinyl alcohol unit as a main repeating unit (PVA) . In the polymer, the proportion of the mole number of a vinyl alcohol unit relative to the mole number of all repeating units is commonly 50% or more, preferably 65% or more, more preferably 70% or more, and, for example, 75% or more. Substantially all the repeating units may be composed of a vinyl alcohol unit. In PVA, the types of repeating units other than the vinyl alcohol unit is not limited to particular types, and can be one or more units selected from a vinyl acetate unit, a vinyl propionate unit, and a vinyl hexanoate unit, for example.

Other examples of the optional polymer that can be contained in the composition for polishing silicon wafers disclosed here include cellulose derivatives such as hydroxyethyl cellulose, hydroxypropyl cellulose, hydroxyethylmethyl cellulose, hydroxypropylmethyl cellulose, methyl cellulose, ethyl cellulose, ethylhydroxyethyl cellulose, and carboxymethyl cellulose and pullulan.

In the composition for polishing silicon wafers disclosed here, the relation between the molecular weight Mₓ of the amido group-containing polymer X and the molecular weight M_{y} of the organic compound Y satisfies the expression: 200 ≤ M_{y} < Mₓ. When the molecular weight M_{y} of the organic compound Y is less than the molecular weight Mₓ of the amido group-containing polymer X, the haze reduction performance and the filterability can be simultaneously achieved at higher levels. Although the reason is not necessarily revealed, it can be supposed that the organic compound Y having a low molecular weight closely adsorbs to a silicon wafer in such a manner as to fill gaps of the amido group-containing polymer X having a high molecular weight at the time of polishing and thus contributes to a haze reduction.

From the viewpoint of haze reduction, filterability, and the like, the ratio of the molecular weight M_{y} of the organic compound Y to the molecular weight Mₓ of the amido group-containing polymer X (M_{y}/Mₓ) is appropriately, substantially (M_{y/}Mₓ) ≤ 0.95, preferably (M_{y}/Mₓ) ≤ 0.7, and more preferably (M_{y}/Mₓ) ≤ 0.5. In a preferred embodiment, the ratio may be (M_{y}/Mₓ) < 0.5 and, for example, may be (M_{y}/Mₓ) ≤ 0.4. The lower limit of (M_{y}/Mₓ) is not limited to particular values, but the ratio is preferably 0.01 ≤ (M_{y}/Mₓ) and more preferably 0.015 ≤ (M_{y}/Mₓ) from the viewpoint of haze reduction effect and the like.

For example, the molecular weight M_{y} of the organic compound Y is typically 2 × 10⁴ or less, preferably 1.8 × 10⁴ or less, more preferably 1.5 × 10⁴ or less, and even more preferably 1.2 × 10⁴ or less from the viewpoint of haze reduction, filterability, and the like. In a preferred embodiment, the molecular weight M_{y} of the organic compound Y may be 1 × 10⁴ or less and, for example, may be 9 × 10³ or less. For example, when polyvinyl alcohol (PVA) is used as the organic compound Y, the molecular weight M_{y} is preferably 2 × 10⁴ or less and more preferably 1.5 × 10⁴ or less. The molecular weight M_{y} of the organic compound Y is typically 2 × 10² or more and is preferably 1 × 10³ or more and more preferably 5 × 10³ or more from the viewpoint of haze reduction and the like. As the molecular weight M_{y} of the organic compound Y, a weight average molecular weight determined by GPC (aqueous system, in terms of polyethylene glycol) or a molecular weight calculated from the chemical formula can be adopted.

Preferred examples of the composition for polishing silicon wafers disclosed here include such a composition that the molecular weight Mₓ of the amido group-containing polymer X is 2 × 10⁴ < Mₓ ≤ 5 × 10⁴ and the molecular weight M_{y} of the organic compound Y is 2 × 10² ≤ M_{y} ≤ 2 × 10⁴, such a composition that the molecular weight Mₓ of the amido group-containing polymer X is 2 × 10⁴ ≤ Mₓ ≤ 4 × 10⁴ and the molecular weight M_{y} of the organic compound Y is 3 × 10² ≤ M_{y} ≤ 1.5 × 10⁴, such a composition that the molecular weight Mₓ of the amido group-containing polymer X is 2.2 × 10⁴ ≤ Mₓ ≤ 3 × 10⁴ and the molecular weight M_{y} of the organic compound Y is 3 × 10³ ≤ M_{y} ≤ 1.2 × 10⁴, and such a composition that the molecular weight Mₓ of the amido group-containing polymer X is 2.4 × 10⁴ ≤ Mₓ ≤ 2.8 × 10⁴ and the molecular weight M_{y} of the organic compound Y is 3.5 × 10³ ≤ M_{y} ≤ 1 × 10⁴. When the amido group-containing polymer X and the organic compound Y have such molecular weights as in the above ranges, the haze reduction performance and the filterability can be simultaneously achieved at higher levels.

### <Water>

The composition for polishing silicon wafers disclosed here typically includes, in addition to the amido group-containing polymer X, water. As the water, ion-exchanged water (deionized water), pure water, ultrapure water, and distilled water can be preferably used, for example. In the water used, the total content of transition metal ions is preferably 100 ppb or less, for example, in order to avoid the inhibition of functions of other components contained in the composition for polishing silicon wafers as much as possible. For example, the water purity can be increased by an ion exchange resin to remove impurity ions, by a filter to remove foreign substances, distillation, or similar operations.

The composition for polishing silicon wafers disclosed here may further contain an organic solvent homogeneously miscible with water (such as lower alcohols and lower ketones), as needed. Commonly, 90% by volume or more of the solvent contained in the composition for polishing silicon wafers is preferably water, and 95% by volume or more (typically, 99% by volume or more and 100% by volume or less) of the solvent is more preferably water.

The composition for polishing silicon wafers (typically, a slurry composition) disclosed here can be preferably provided, for example, in such a form that the non-volatile content (NV) is 0.01% by mass or more and 50% by mass or less and the remainder is an aqueous solvent (water or a mixed solvent of water and the above-mentioned organic solvent) or the remainder is an aqueous solvent and a volatile compound (such as ammonia). More preferred is a form in which the non-volatile content NV is 0.05% by mass or more and 40% by mass or less. The non-volatile content (NV) is the mass proportion of the residues after a composition for polishing silicon wafers is dried at 105°C for 24 hours, relative to the composition for polishing silicon wafers.

### <Abrasive grains>

The composition for polishing silicon wafers disclosed here is used in the presence of abrasive grains. The abrasive grains have a function of mechanically polishing the surface of silicon wafers. In the composition for polishing silicon wafers disclosed here, the abrasive grains also have a function of rubbing the amido group-containing polymer X that has adsorbed to the surface of the abrasive grains against a silicon wafer or a function of removing the amido group-containing polymer X that has adsorbed to a silicon wafer. This adjusts the chemical polishing by a silicon-wafer polishing accelerator.

In the present description, "a composition for polishing silicon wafers being used in the presence of abrasive grains" can includes an embodiment in which a composition for polishing silicon wafers contains abrasive grains. Such an embodiment can be understood as a preferred embodiment of the composition for polishing silicon wafers disclosed here. Accordingly, "a composition for polishing silicon wafers being used in the presence of abrasive grains" can also be mentioned as "a composition for polishing silicon wafers containing abrasive grains". Alternatively, abrasive grains can be used in the form of fixed abrasive grains included in a polishing pad, for example.

Materials of the abrasive grains disclosed here are not limited to particular materials and can be appropriately selected according to an intended purpose and a usage form of the composition for polishing silicon wafers, for example. Examples of the abrasive grains include inorganic particles, organic particles, and organic-inorganic composite particles.

Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and colcothar particles; nitride particles such as silicon nitride particles and boron nitride particles; carbide particles such as silicon carbide particles and boron carbide particles; diamond particles; and carbonates such as calcium carbonate and barium carbonate. Specific examples of the organic particles include polymethyl methacrylate (PMMA) particles, poly(meth)acrylic acid particles (here, the (meth)acrylic acid inclusively means acrylic acid and methacrylic acid), and polyacrylonitrile particles. Such abrasive grain types may be used singly or in combination of two or more of them.

The abrasive grains are preferably inorganic particles, and specifically preferably particles of a metal oxide or a metalloid oxide. The abrasive grains usable in the technique disclosed here are preferably exemplified by silica particles. The reason for this is as follows: When silica particles composed of oxygen atoms and the same element as an object to be polished (silicon wafer) are used as the abrasive grains, residues of a different metal or a different metalloid from silicon are not generated after polishing, and this eliminates the possibility of contamination of the surface of a silicon wafer or of deterioration of electrical properties as a silicon wafer due to diffusion of a different metal or a different metalloid from silicon in an object to be polished.

As a preferred embodiment of the composition for polishing silicon wafers from such a viewpoint, a composition for polishing silicon wafers containing silica particles alone as the abrasive grains is exemplified. In addition, the silica has such characteristics that highly pure silica is easily available. This is also exemplified as the reason why the silica particles are preferred as the abrasive grains. Specific examples of the silica particles include colloidal silica, fumed silica, and precipitated silica.

From the viewpoint that scratches are unlikely to be generated on the surface of an object to be polished and a surface having a lower haze can be achieved, preferred examples of the silica particles include colloidal silica and fumed silica. Of them, colloidal silica is preferred. Specifically, colloidal silica can be preferably adopted as the abrasive grains in a composition for polishing silicon wafers used for polishing (especially, final polishing) of silicon wafers.

The silica constituting the silica particles preferably has a true specific gravity of 1.5 or more, more preferably 1.6 or more, and even more preferably 1.7 or more. Silica having a larger true specific gravity enables an improvement of polishing rate (the removal amount of the surface of an object to be polished per unit time) at the time of polishing of a silicon wafer. From the viewpoint of reducing scratches generated on the surface (polished face) of an object to be polished, silica particles having a true specific gravity of 2.2 or less are preferred. As the true specific gravity of silica, a measured value determined by a liquid displacement method using ethanol as the displacement liquid can be adopted.

In the technique disclosed here, the abrasive grains included in the composition for polishing silicon wafers may be in the form of primary particles or in the form of secondary particles formed by assembly of a plurality of primary particles. Abrasive grains in the form of primary particles may be mixed with abrasive grains in the form of secondary particles. In a preferred embodiment, at least some of the abrasive grains are contained in the form of secondary particles in the composition for polishing silicon wafers.

The average primary particle size D_{P1} of the abrasive grains is not limited to particular values, but is preferably 5 nm or more and more preferably 10 nm or more from the viewpoint of polishing efficiency, for example. From the viewpoint of achieving higher polishing effect, the average primary particle size D_{P1} is preferably 15 nm or more and more preferably 20 nm or more (for example, more than 20 nm). From the viewpoint of easily giving a surface with higher smoothness, the average primary particle size D_{P1} is typically, appropriately 100 nm or less, preferably 50 nm or less, and more preferably 40 nm or less. From the viewpoint of easily giving a higher-quality surface and the like, the average primary particle size D_{P1} is preferably 35 nm or less (typically, less than 30 nm) and more preferably 25 nm or less. In a preferred embodiment, the average primary particle size D_{P1} of the abrasive grains may be less than 25 nm and, for example, 24 nm or less.

In the technique disclosed here, the average primary particle size D_{P1} of abrasive grains can be, for example, calculated in accordance with the equation, average primary particle size D_{P1} (nm) = 2727/S where S is the specific surface area (m²/g) determined by the BET method. The specific surface area of abrasive grains can be determined by using a surface area analyzer, trade name "Flow Sorb II 2300" manufactured by Micromeritics, for example.

The average secondary particle size D_{P2} of the abrasive grains is preferably 10 nm or more and more preferably 20 nm or more from the viewpoint of polishing rate, for example. From the viewpoint of achieving higher polishing effect, the average secondary particle size D_{P2} is preferably 30 nm or more, more preferably 35 nm or more, and even more preferably 40 nm or more (for example, more than 40 nm). From the viewpoint of giving a surface with higher smoothness, the average secondary particle size D_{P2} of abrasive grains is appropriately 200 nm or less, preferably 150 nm or less, and more preferably 100 nm or less. The technique disclosed here can also be preferably performed in such an embodiment as to use abrasive grains having an average secondary particle size D_{P2} of less than 70 nm (more preferably 60 nm or less, for example, less than 50 nm) from the viewpoint of easily giving a higher-quality surface and the like.

The average secondary particle size D_{P2} of abrasive grains can be determined by the following procedure. An aqueous dispersion liquid of intended abrasive grains is used as a measurement sample, and is subjected to dynamic light scattering by using a particle size distribution analyzer, model "UPA-UT151" manufactured by NIKKISO CO., LTD., for example. The concentration of abrasive grains in an aqueous dispersion liquid as the measurement sample is not limited to particular values, but from the viewpoint of measurement accuracy, the concentration of abrasive grains is preferably 0.5% by mass or less and more preferably 0.2% by mass or less.

The average secondary particle size D_{P2} of abrasive grains is commonly equal or more than the average primary particle size D_{P1} of the abrasive grains (D_{P2}/D_{P1} ≥ 1) and is typically more than D_{P1} (D_{P2}/D_{P1} > 1). Although not critical, from the viewpoint of polishing effect and surface smoothness after polishing, the D_{P2}/D_{P1} of the abrasive grains is commonly, appropriately in a range of 1.2 or more and 3 or less, preferably in a range of 1. 5 or more and 2.5 or less, and more preferably in a range of 1.7 or more and 2.3 or less (for example, more than 1.8 and not more than 2.2).

The shape (outer shape) of the abrasive grains may be spherical or nonspherical. Specific examples of the shape of nonspherical abrasive grains include a peanut-like shape (or a peanut shell-like shape), a cocoon-like shape, a konpeito- (pointed sugar candy ball-) like shape, and a rugby ball-like shape. For example, abrasive grains in which many of the abrasive grains have a peanut-like shape can be preferably adopted.

The average of major axis length/minor axis length ratios (average aspect ratio) of primary particles of the abrasive grains is not limited to particular values, but is preferably 1.05 or more and more preferably 1.1 or more. When the abrasive grains have a larger average aspect ratio, a higher polishing rate can be achieved. The abrasive grains preferably has an average aspect ratio of 3.0 or less, more preferably 2.0 or less, and even more preferably 1. 5 or less from the viewpoint of reducing scratches, for example.

The shape (outer shape) and the average aspect ratio of the abrasive grains can be determined by observation under an electron microscope, for example. Specific procedures for determining the average aspect ratio are as follows: For example, a predetermined number (for example, 200 pieces) of abrasive grains that can be identified to have independent particle shapes are observed under a scanning electron microscope (SEM), and a rectangle is circumscribed around each grain image so as to have a minimum area. The long side length (major axis length) of the rectangle circumscribing each grain image is divided by the short side length (minor axis length), and the calculated value is regarded as the major axis length/minor axis length ratio (aspect ratio). The arithmetic mean of the aspect ratios of the predetermined number of grains can be calculated to give the average aspect ratio.

### <Silicon-wafer polishing accelerator>

The composition for polishing silicon wafers disclosed here typically includes, in addition to the amido group-containing polymer X, the organic compound Y, and the water, a silicon-wafer polishing accelerator. The silicon-wafer polishing accelerator contained in the composition for polishing silicon wafers is a component that has a function of chemically polishing a surface to be polished and contributes to an improvement of polishing rate. The silicon-wafer polishing accelerator has a function of chemically etching silicon and is typically a basic compound. The basic compound contained in a composition for polishing silicon wafers increases the pH of the composition for polishing silicon wafers and improves the dispersion state of the abrasive grains or the amido group-containing polymer X. The basic compound thus can help the composition for polishing silicon wafers to have higher dispersion stability and the abrasive grains to achieve higher mechanical polishing performance.

As the basic compound, nitrogen-containing organic or inorganic basic compounds, hydroxides of alkali metals or alkaline earth metals, and various carbonates and hydrogen carbonates can be used. Examples of the basic compound include hydroxides of alkali metals, hydroxides of quaternary ammoniums or salts thereof, ammonia, and amines. Specific examples of the hydroxides of alkali metals include potassium hydroxide and sodium hydroxide. Specific examples of the carbonates and the hydrogen carbonates include ammonium hydrogen carbonate, ammonium carbonate, potassium hydrogen carbonate, potassium carbonate, sodium hydrogen carbonate, and sodium carbonate. Specific examples of the hydroxides of quaternary ammoniums or salts thereof include tetramethylammonium hydroxide, tetraethylammonium hydroxide, and tetrabutylammonium hydroxide. Specific examples of the amine include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl)piperazine, N-methylpiperazine, guanidine, and azoles such as imidazole and triazole. These basic compounds can be used singly or in combination of two or more of them.

Preferred examples of the basic compound from the viewpoint of improvement of polishing rate and the like include ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate, and sodium carbonate. Specifically preferred examples include ammonia, potassium hydroxide, sodium hydroxide, tetramethylammonium hydroxide, and tetraethylammonium hydroxide. More preferred examples include ammonia and tetramethylammonium hydroxide. As a particularly preferred basic compound, ammonia is exemplified.

### <Other components>

The composition for polishing silicon wafers disclosed here can further contain known additives usable in polishing compositions (typically, polishing compositions used for final polishing of silicon wafers), such as a chelating agent, an organic acid, an organic acid salt, an inorganic acid, an inorganic acid salt, an antiseptic agent, and a fungicide, as needed, to such an extent as not to markedly suppress effects of the invention.

Examples of the chelating agent include aminocarboxylic acid chelating agents and organic phosphonic acid chelating agents. Examples of the aminocarboxylic acid chelating agent include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraminehexaacetic acid, and sodium triethylenetetraminehexaacetate.

Examples of the organic phosphonic acid chelating agent include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid.

Among them, organic phosphonic acid chelating agents are more preferred, and ethylenediaminetetrakis(methylenephosphonic acid) and diethylenetriaminepenta(methylenephosphonic acid) are even more preferred. As a particularly preferred chelating agent, ethylenediaminetetrakis(methylenephosphonic acid) is exemplified.

Examples of the organic acid include fatty acids such as formic acid, acetic acid, and propionic acid and aromatic carboxylic acids such as benzoic acid and phthalic acid. Examples of the organic acid further include citric acid, oxalic acid, tartaric acid, malic acid, maleic acid, fumaric acid, succinic acid, organic sulfonic acids, and organic phosphonic acids. Examples of the organic acid salt include alkali metal salts (including sodium salts and potassium salts) of organic acids and ammonium salts of organic acids.

Examples of the inorganic acid include sulfuric acid, nitric acid, hydrochloric acid, and carbonic acid. Examples of the inorganic acid salt include alkali metal salts (including sodium salts and potassium salts) of inorganic acids and ammonium salts of inorganic acids. The organic acids and salts thereof and the inorganic acids and salts thereof can be used singly or in combination of two or more of them.

Examples of the antiseptic agent and the fungicide include isothiazoline compounds, p-hydroxybenzoate esters, and phenoxyethanol.

### <Application of composition for polishing silicon wafers>

The composition for polishing silicon wafers disclosed here can be used for polishing objects to be polished composed of single crystalline silicon (silicon wafers). The object to be polished may have any shape. The composition for polishing silicon wafers disclosed here can be preferably applied for polishing an object to be polished having, for example, a plate-like shape or a polyhedron shape with a flat surface or for polishing an edge of an object to be polished (for example, polishing a wafer edge).

The composition for polishing silicon wafers disclosed here can be preferably used for final polishing of an object to be polished. Hence, the present description provides a method for producing polished objects, including a final polishing step using the composition for polishing silicon wafers (for example, a method for producing silicon wafers) . The final polishing means the last polishing step in a production process of target products (in other words, the step after which no further polishing is performed).

The composition for polishing silicon wafers disclosed here can be used in a polishing step at the upstream side of the final polishing (a preliminary polishing step between a rough polishing step and the final polishing step; typically including at least a primary polishing step, and capable of including further polishing steps such as a secondary polishing step and a tertiary polishing step) and, for example, in a polishing step immediately before the final polishing.

The composition for polishing silicon wafers disclosed here is effectively applied to polishing of a silicon wafer prepared by a polishing step at the upstream side of the final polishing to have a surface condition with a surface roughness of 0.01 nm or more and 100 nm or less (typically to the final polishing or polishing immediately before the final polishing), for example.

### <Polishing liquid>

The composition for polishing silicon wafers disclosed here is supplied to an object to be polished typically in the form of a polishing liquid containing the composition for polishing silicon wafers, and is used for polishing the object to be polished. The polishing liquid can be prepared by diluting any of the compositions for polishing silicon wafers disclosed here (typically diluted with water), for example. Alternatively, the composition for polishing silicon wafers may be used without any treatment as the polishing liquid.

In other words, the concept of the composition for polishing silicon wafers in the technique disclosed here encompasses both a polishing liquid that is supplied to an object to be polished and is used for polishing the object to be polished (working slurry) and a concentrated liquid that is diluted and used as a polishing liquid (a stock solution of a polishing liquid). Other examples of the polishing liquid containing the composition for polishing silicon wafers disclosed here include a polishing liquid prepared by adjusting the pH of the composition for polishing silicon wafers.

The content of the amido group-containing polymer X in the polishing liquid is not limited to particular values and can be 1 × 10⁻⁴% by mass or more, for example. From the viewpoint of reducing haze and the like, the content is preferably 5 × 10⁻⁴% by mass or more, more preferably 1 × 10⁻³% by mass or more, and, for example, 2 × 10⁻³% by mass or more. From the viewpoint of polishing rate and the like, the content of the amido group-containing polymer X in the polishing liquid is preferably 0.2% by mass or less and more preferably 0.1% by mass or less (for example, 0.05% by mass or less).

The content of the organic compound Y in the polishing liquid is not limited to particular values and can be 1 × 10⁻⁵% by mass or more, for example. From the viewpoint of haze reduction, filterability, and the like, the content is preferably 3 × 10⁻⁵% by mass or more, more preferably 5 × 10⁻⁵% by mass or more, and, for example, 8 × 10⁻⁵% by mass or more. The content of the organic compound Y in the polishing liquid is preferably 0.2% by mass or less and more preferably 0.1% by mass or less (for example, 0.05% by mass or less).

The mass ratio of the content w1 of the amido group-containing polymer X and the content w2 of the organic compound Y (w1/w2) is not limited to particular values, but can be, for example, in a range of 0.01 or more and 1,000 or less, preferably in a range of 0.05 or more and 500 or less, more preferably in a range of 0.1 or more and 200 or less, and even more preferably in a range of 0.5 or more and 150 or less.

When the composition for polishing silicon wafers disclosed here contains abrasive grains, the content of the abrasive grains in the polishing liquid is not limited to particular values, but is typically 0.01% by mass or more, preferably 0.05% by mass or more, more preferably 0.1% by mass or more, and, for example, 0.15% by mass or more. When the content of the abrasive grains is increased, a higher polishing rate can be achieved. From the viewpoint of achieving a surface with a lower haze, the content of the abrasive grains in the polishing liquid is commonly, appropriately 10% by mass or less, preferably 7% by mass or less, more preferably 5% by mass or less, even more preferably 2% by mass or less, and, for example, 1% by mass or less.

The content of the silicon-wafer polishing accelerator in the polishing liquid disclosed here is not limited to particular values. From the viewpoint of an improvement of polishing rate and the like, the content is commonly, preferably 0.001% by mass or more of the polishing liquid and is more preferably 0.003% by mass or more. From the viewpoint of reducing haze and the like, the content of the silicon-wafer polishing accelerator in the polishing liquid is preferably less than 0.4% by mass and more preferably less than 0.25% by mass.

The lower limit of the pH of the polishing liquid is not limited to particular values. For example, the pH is preferably 8.0 or more, more preferably 9.0 or more, and most preferably 9.5 or more. When the polishing liquid has a pH of 8.0 or more (more preferably 9.0 or more, most preferably 9.5 or more), the polishing rate of a silicon wafer is improved, and a silicon wafer with high surface accuracy can be efficiently produced. In addition, the dispersion stability of particles in the polishing liquid is improved.

The upper limit of the pH of the polishing liquid is not limited to particular values, but is preferably 12.0 or less and more preferably 11.0 or less. When the polishing liquid has a pH of 12.0 or less (more preferably 11.0 or less), the abrasive grains (especially, silica particles such as colloidal silica, fumed silica, and precipitated silica) contained in the polishing liquid are prevented from dissolving due to a basic compound, and a reduction of the mechanical polishing performance of the abrasive grains can be suppressed.

The pH can be adjusted by the above-mentioned basic compound or an organic acid or an inorganic acid of the above-mentioned other components. The pH value can be preferably applied to a polishing liquid used for polishing silicon wafers (for example, a polishing liquid for final polishing). The pH of a polishing liquid is determined as follows: A pH meter (for example, a glass electrode-type hydrogen ion concentration indicator (model: F-23) manufactured by Horiba, Ltd.) and standard buffer solutions (a phthalate pH buffer solution with a pH of 4.01 (25°C), a neutral phosphate pH buffer solution with a pH of 6.86 (25°C), and a carbonate pH buffer solution with a pH of 10.01 (25°C)) were used to perform three-point calibration. The glass electrode is then immersed in a polishing liquid, and after 2 minutes, a stabilized value is recorded.

### <Concentrated liquid>

The composition for polishing silicon wafers disclosed here may be in a concentrated form (that is, the form of a concentrated liquid of the polishing liquid) before supplied to an object to be polished. The composition for polishing silicon wafers in such a concentrated liquid form has advantages from the viewpoint of the convenience at the time of production, distribution, storage, and the like and cost reduction, for example. The concentration rate can be, for example, about 2 or more and 100 or less and is commonly, appropriately about 5 or more and 50 or less in terms of volume . The concentration rate of a composition for polishing silicon wafers pertaining to a preferred embodiment is 10 or more and 40 or less and, for example, 15 or more and 25 or less.

The composition for polishing silicon wafers in such a concentrated liquid form can be used in such a way that the polishing composition is diluted at an appropriate timing to give a polishing liquid, and the polishing liquid is supplied to an object to be polished. The dilution can be typically performed by adding the above-mentioned aqueous solvent to the concentrated liquid and mixing the whole. When the aqueous solvent is a mixed solvent, some of the components in the aqueous solvent may be added for dilution, or a mixed solvent containing these components at a ratio different from that of the aqueous solvent may be added for dilution. For a multi-pack type composition for polishing silicon wafers as described later, some of the packed components may be diluted, and then the other packed components may be mixed to prepare a polishing liquid. Alternatively, a plurality of packed components may be mixed, and then the mixture may be diluted to prepare a polishing liquid,

The NV of the concentrated liquid can be 50% by mass or less, for example. From the viewpoint of stability of the composition for polishing silicon wafers (for example, dispersion stability of abrasive grains), filterability, and the like, the NV of the concentrated liquid is commonly, appropriately 40% by mass or less, preferably 30% by mass or less, more preferably 20% by mass or less, and, for example, 15% by mass or less. From the viewpoint of the convenience at the time of production, distribution, storage, and the like, cost reduction, and the like, the NV of the concentrated liquid is appropriately 0.5% by mass or more, preferably 1% by mass or more, more preferably 3% by mass or more, and, for example, 5% by mass or more.

The content of the amido group-containing polymer X in the concentrated liquid can be 3% by mass or less, for example. From the viewpoint of filterability of the composition for polishing silicon wafers, cleanability, and the like, the content of the amido group-containing polymer X in the concentrated liquid is commonly, preferably 1% by mass or less and more preferably 0.5% by mass or less. From the viewpoint of the convenience at the time of production, distribution, storage, and the like, cost reduction, and the like, the content of the amido group-containing polymer X in the concentrated liquid is commonly, appropriately 1 × 10⁻³% by mass or more, preferably 5 × 10⁻³% by mass or more, and more preferably 1 × 10⁻²% by mass or more.

The content of the organic compound Y in the concentrated liquid can be 2% by mass or less, for example. From the viewpoint of the filterability of the composition for polishing silicon wafers and the like, the content of the organic compound Y in the concentrated liquid is commonly, preferably 1% by mass or less and more preferably 0.5% by mass or less. From the viewpoint of the convenience at the time of production, distribution, storage, and the like, cost reduction, and the like, the content of the organic compound Y in the concentrated liquid is commonly, appropriately 1 × 10⁻⁵% by mass or more.

When the composition for polishing silicon wafers disclosed here contains abrasive grains, the content of the abrasive grains in the concentrated liquid can be 50% by mass or less, for example. From the viewpoint of stability of the composition for polishing silicon wafers (for example, dispersion stability of abrasive grains), filterability, and the like, the content of the abrasive grains in the concentrated liquid is commonly, preferably 45% by mass or less and more preferably 40% by mass or less. In a preferred embodiment, the content of the abrasive grains in the concentrated liquid may be 30% by mass or less and may be 20% by mass or less (for example, 15% by mass or less) . From the viewpoint of the convenience at the time of production, distribution, storage, and the like, cost reduction, and the like, the content of the abrasive grains in the concentrated liquid can be, for example, 0.5% by mass or more and is preferably 1% by mass or more and more preferably 3% by mass or more (for example, 5% by mass or more).

The composition for polishing silicon wafers disclosed here may be a one-pack type or a multi-pack type including a two-pack type. For example, the composition for polishing silicon wafers can be composed in such a manner that a liquid A containing some of the components of the composition for polishing silicon wafers (for example, a dispersion liquid containing abrasive grains (such as silica particles), a silicon-wafer polishing accelerator, and water) is mixed with a liquid B containing the remaining components (for example, a liquid containing an amido group-containing polymer X and an organic compound Y), and the mixture is used for polishing an object to be polished. Alternatively, a composition for polishing silicon wafers containing a silicon-wafer polishing accelerator, an amido group-containing polymer X, an organic compound Y, and water can be used in such a manner as to be mixed with separately prepared abrasive grains at an appropriate timing.

### <Preparation of composition for polishing silicon wafers>

The production method of the composition for polishing silicon wafers disclosed here is not limited to particular methods. For example, a well-known mixer such as a blade-type stirrer, an ultrasonic disperser, and a homomixer is used to mix components contained in the composition for polishing silicon wafers. The manner of mixing these components is not limited to particular manners. For example, all the components may be concurrently mixed, or the components may be mixed in an appropriate order.

### <Polishing>

The composition for polishing silicon wafers disclosed here can be used for polishing an object to be polished in such a manner as to include the following operations, for example. A preferred embodiment of the method for polishing an object to be polished by using the composition for polishing silicon wafers disclosed here will next be described.

In other words, a polishing liquid (typically, a polishing liquid in a slurry form, also called a polishing slurry) containing any of the compositions for polishing silicon wafers disclosed here is prepared. The preparing a polishing liquid can include preparing a polishing liquid by subjecting a composition for polishing silicon wafers to concentration adjustment (for example, dilution), pH adjustment, or other operations. Alternatively, the composition for polishing silicon wafers may be used as the polishing liquid without any treatment. For a multi-pack type composition for polishing silicon wafers, the preparing a polishing liquid can include mixing packed components, diluting one or a plurality of packed components before the mixing, and diluting the mixture after the mixing, for example.

Next, the polishing liquid is supplied to an object to be polished, and the object is polished in usual ways. For example, when a silicon wafer is subjected to final polishing, a silicon wafer that has been subjected to a lapping step and a preliminary polishing step is set to a common polishing apparatus, and the polishing liquid is supplied to a surface (face to be polished) of the silicon wafer through a polishing pad on the polishing apparatus. Typically, while the polishing liquid is continuously supplied, the polishing pad is pressed against the surface of the silicon wafer, and the polishing pad and the silicon wafer are relatively moved (for example, rotationally moved). Through the polishing step, the polishing of the object to be polished is completed.

The polishing pad used in the polishing step may be any polishing pad. For example, any of nonwoven fabric polishing pads, suede polishing pads, pads containing abrasive grains, and pads containing no abrasive grains can be used.

### <Rinsing>

The object polished by using the composition for polishing silicon wafers disclosed here and containing abrasive grains can be rinsed with a rinse solution that contains the same components as in the composition for polishing silicon wafers but contains no abrasive grains. In other words, the method of polishing the above object to be polished by using the above composition for polishing silicon wafers may include a step of rinsing the object to be polished by using a rinse solution that contains the same components as in the composition for polishing silicon wafers but contains no abrasive grains (rinsing step).

The rinsing step enables a reduction of residues such as abrasive grains that can cause surface defects or haze of an object to be polished. The rinsing step may be performed between a polishing step and another polishing step or may be performed after the final polishing step and before the cleaning step described later. Rinsing with the rinse solution that contains the same components as in the composition for polishing silicon wafers but contains no abrasive grains enables a further reduction of defects or haze without impairing the function of the amido group-containing polymer X that has adsorbed onto the surface of a silicon wafer.

Such a rinse solution can typically be a composition for polishing silicon wafers containing a silicon-wafer polishing accelerator, an amido group-containing polymer X, and water (specifically a composition used for rinsing a polished silicon wafer; also called a rinsing composition) . The formulation and the like of the silicon wafer rinsing composition are basically the same as those of the above-mentioned composition for polishing silicon wafers except that no abrasive grains are contained, and the explanation is not repeated.

### <Cleaning>

An object polished by using the composition for polishing silicon wafers disclosed here is typically cleaned after polishing (after rinsing as needed). The cleaning can be performed by using an appropriate cleaning solution. The cleaning solution used may be any cleaning solution. For example, an SC-1 cleaning solution (a mixed solution of ammonium hydroxide (NH₄OH), hydrogen peroxide (H₂O₂), and water (H₂O); hereinafter, cleaning with the SC-1 cleaning solution is called "SC-1 cleaning") or an SC-2 cleaning solution (a mixed solution of HCl, H₂O₂, and H₂O), which are commonly used in the field of semiconductors and the like, can be used. The temperature of the cleaning solution is room temperature or higher and about 90°C or lower, for example. From the viewpoint of improving cleaning efficiency, a cleaning solution at about 50°C or more and 85°C or less can be preferably used.

Some examples relating to the present invention will next be described, but the present invention is not intended to be limited to these examples. In the following description, "part" and "%" are in terms of mass unless otherwise specified.

### <Preparation of composition for polishing silicon wafers>

### (Example 1)

Abrasive grains, a water-soluble polymer, an organic compound, aqueous ammonia (a concentration of 29%), and deionized water were mixed to prepare a concentrated liquid of a polishing composition. The concentrated liquid was diluted with deionized water 20 times to give a polishing composition of Example 1.

As the abrasive grains, colloidal silica having an average primary particle size of 35 nm was used. The average primary particle size was determined by using a surface area analyzer, trade name "Flow Sorb II 2300" manufactured by Micromeritics.

As the water-soluble polymer, a polymer of N-(2-hydroxyethyl)acrylamide having an Mw of 2.5 × 10⁴ (hereinafter called "HEAA") was used.

As the organic compound, a PEO-PPO-PEO-type triblock copolymer having an Mw of 9 × 10³ (including PPO at the center moiety and PEO at each terminal; hereinafter called "PEO-PPO-PEO") was used.

The abrasive grains, the water-soluble polymer, the organic compound, and the aqueous ammonia were used in such amounts that the content of the abrasive grains was 0.46%, the content of the water-soluble polymer was 0.015%, the content of the organic compound was 0.0025%, and the content of ammonia (NH₃) was 0.010% in the polishing composition.

### (Example 2)

A polishing composition of Example 2 was prepared in the same manner as in Example 1 except that the content of HEAA in the polishing composition was 0.008%.

### (Example 3)

A polishing composition of Example 3 was prepared in the same manner as in Example 1 except that polyoxyethylene decyl ether (the addition molar number of ethylene oxide was 5) having a molecular weight of 378 (hereinafter called "C10PEO5") was used as the organic compound and the content of C10PEO5 in the polishing composition was 0.0001%.

### (Example 4)

A polishing composition of Example 4 was prepared in the same manner as in Example 1 except that polyvinyl alcohol (the vinyl alcohol unit was contained at 80% by mole; the vinyl hexanoate unit was contained at 20% by mole; hereinafter called "PVA") having an Mw of 1.2 × 10⁴ was used as the organic compound, the content of PVA in the polishing composition was 0.005%, and the content of HEAA was 0.005%.

### (Comparative Example 1)

A polishing composition of Comparative Example 1 was prepared in the same manner as in Example 1 except that PEO-PPO-PEO was not used.

### (Comparative Example 2)

A polishing composition of Comparative Example 2 was prepared in the same manner as in Example 1 except that polyvinylpyrrolidone having an Mw of 4.5 × 10⁴ (hereinafter called "PVP") was used in place of PEO-PPO-PEO.

### (Comparative Example 3)

A polishing composition of Comparative Example 3 was prepared in the same manner as in Example 1 except that hydroxyethyl cellulose having an Mw of 2.5 × 10⁵ (hereinafter called "HEC") was used in place of HEAA.

### <Polishing of silicon wafer>

The polishing composition of each example was used without any treatment as a polishing liquid to polish the surface of a silicon wafer under the following conditions. The silicon wafer used was prepared as follows: A p-type silicon wafer having a diameter of 300 mm, a crystal orientation of <100>, and a resistivity of not less than 0.1 Ω·cm and less than 100 Ω·cm, prepared by rough polishing was subjected to preliminary polishing by using a polishing slurry (manufactured by Fujimi, Inc., trade name "GLANZOX 2100") to adjust the surface roughness to 0.1 nm or more and 10 nm or less.

### <Polishing conditions>

Polishing apparatus: a single wafer polishing machine, model "PNX-332B" manufactured by Okamoto Machine Tool Works, Ltd.

Polishing table: the latter two tables of three tables of the polishing apparatus were used to perform the first and second steps of final polishing after the preliminary polishing.

### (the following conditions were applied to each table)

Polishing load: 15 kPa
Rotation rate of surface plate: 30 rpm
Rotation rate of head: 30 rpm
Polishing time: 2 minutes
Temperature of polishing liquid: 20°C
Supply rate of polishing liquid: 2.0 liter/min

### (free-flowing)

### <Cleaning>

A cleaning solution prepared by mixing aqueous ammonia (an NH₄OH concentration of 29% by mass), aqueous hydrogen peroxide (an H₂O₂ concentration of 31% by mass), and deionized water (DIW) at a ratio of aqueous ammonia:aqueous hydrogen peroxide:deionized water = 1:3:30 (volume ratio) was used to clean the silicon wafer after polishing (SC-1 cleaning).

More specifically, two cleaning chambers each equipped with an ultrasonic oscillator at a frequency of 950 kHz were prepared, and the cleaning solution was placed in each of the first and second cleaning chambers and kept at 60°C. Next, a silicon wafer after polishing was immersed in the cleaning solution in the first cleaning chamber for 6 minutes while the ultrasonic oscillator was activated, then was immersed and rinsed in ultrapure water in a rinse chamber while an ultrasonic oscillator was activated, and was further immersed in the cleaning solution in the second cleaning chamber for 6 minutes while the ultrasonic oscillator was activated.

### <Measurement of haze>

The haze (in terms of ppm) of the surface of a silicon wafer after cleaning was measured by using a wafer inspection apparatus, trade name "Surfscan SP2" manufactured by KLA-Tencor in a DWO mode. The obtained results were converted into relative values where the haze value of Comparative Example 1 was 100%, and are shown in Table 1.

### <Evaluation of filterability>

The filterability of a polishing composition was evaluated by the following procedure. In other words, the polishing composition of each example (i.e., a polishing composition prepared by diluting a concentrated liquid of a polishing composition 20 times) was subjected to suction filtration in conditions of a temperature of 25°C and a filter differential pressure of 50 kPa. The filter used was a disc filter, trade name "Ultipor (registered trademark) N66" (a diameter of 47 mm, a filtration accuracy of 0.2 µm) manufactured by Pall Japan.

The volume of a polishing composition that had passed through the filter until the flow of the polishing composition passing through the filter stopped was determined, and the filterability was evaluated from the volume into the following two levels. The obtained results are shown in the column "filterability" in Table 1.
A: the volume of a polishing composition that has passed through the filter is 200 mL or more.
C: the volume of a polishing composition that has passed through the filter is less than 200 mL.

**[Table 1]**

| | Water-soluble polymer | | | Organic compound | | | Haze (%) | Filterability |
|---|---|---|---|---|---|---|---|---|
| | Type | Mw | Content (wt%) | Type | Mw | Content (wt%) | | |
| Example 1 | HEAA | 25000 | 0.015 | PEO-PPO-PEO | 9000 | 0.0025 | 65 | A |
| Example 2 | HEAA | 25000 | 0.008 | PEO-PPO-PEO | 9000 | 0.0025 | 55 | A |
| Example 3 | HEAA | 25000 | 0.015 | C10PEO5 | 378 | 0.0001 | 60 | A |
| Example 4 | HEAA | 25000 | 0.005 | PVA | 12000 | 0.005 | 75 | A |
| Comparative Example 1 | HEAA | 25000 | 0.015 | - | - | - | 100 | A |
| Comparative Example 2 | HEAA | 25000 | 0.015 | PVP | 45000 | 0.0050 | 110 | A |
| Comparative Example 3 | HEC | 250000 | 0.015 | PEO-PPO-PEO | 9000 | 0.0025 | 60 | C |

As shown in Table 1, the polishing compositions of Examples 1 to 4 containing HEAA having a higher molecular weight and an organic compound having a lower molecular weight in combination each showed excellent haze reduction effect and filterability. Of them, the polishing compositions of Examples 1 to 3 containing PEO-PPO-PEO or C10PEO5 as the organic compound achieved higher haze reduction effect. The polishing composition of Example 2 in which the content of HEAA was 0.008% or less achieved particularly high haze reduction effect.

In contrast, the polishing composition of Comparative Example 1 containing HEAA alone and the polishing composition of Comparative Example 2 containing HEAA having a lower molecular weight and PVP (organic compound) having a higher molecular weight in combination each had an insufficient haze reduction performance. The polishing composition of Comparative Example 3 containing HEC having a higher molecular weight and PEO-PPO-PEO (organic compound) having a lower molecular weight in combination gave a lower haze than that of Comparative Example 1, but had poor filterability, and thus had poor balance between both the performances.

From these results, it can be ascertained that the haze reduction performance and the filterability improvement can be achieved in good balance by using an amido group-containing polymer having a high molecular weight and an organic compound having a low molecular weight in combination.

Specific examples of the present invention have been described in detail hereinbefore, but are merely illustrative examples, and are not intended to limit the scope of claims. The techniques described in the scope of claims include various modifications and changes of the above exemplified specific examples.

## Claims

1. Use of a composition for polishing single crystal silicon wafers, the composition being used in a presence of abrasive grains, the composition comprising:
a silicon-wafer polishing accelerator;
an amido group-containing polymer X;
an organic compound Y having no amido group; and
water,
the amido group-containing polymer X having, on a main chain, a building block A derived from a monomer represented by General Formula (1),
the amido group-containing polymer X having a molecular weight Mₓ of less than 5 × 10⁴,
a relation between a molecular weight Mₓ of the amido group-containing polymer X and a molecular weight M_{y} of the organic compound Y satisfying an expression: 200 ≤ M_{y} < Mₓ: 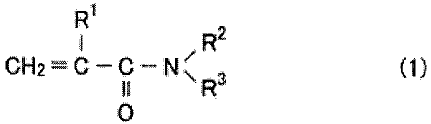 wherein R¹ is a hydrogen atom; an alkyl group, an alkenyl group, an alkynyl group, an aralkyl group, an alkoxy group, an alkoxyalkyl group, or an alkylol group having a carbon number of 1 or more and 6 or less; an acetyl group; a phenyl group; a benzyl group; a chloro group; a difluoromethyl group; a trifluoromethyl group; or a cyano group; and R² and R³ are the same or different and are independently a hydrogen atom; an alkyl group, an alkenyl group, an alkynyl group, an aralkyl group, an alkoxy group, an alkoxyalkyl group, an alkylol group, or an acetyl group having a carbon number of 1 or more and 18 or less; or an aromatic group having a carbon number of 6 or more and 60 or less, where the groups except the hydrogen atom optionally have a substituent, and R² and R³ are not simultaneously a hydrogen atom.

2. The use according to claim 1, wherein a ratio of the molecular weight M_{y} of the organic compound Y to the molecular weight Mₓ of the amido group-containing polymer X (M_{y}/Mₓ) is less than 0.5.

3. The use according to claim 1 or 2, wherein the amido group-containing polymer X is nonionic.

4. The use according to any one of claims 1 to 3, wherein R¹ in the General Formula (1) is a hydrogen atom or a methyl group.

5. The use according to any one of claims 1 to 4, wherein R² and R³ in the General Formula (1) are the same or different and are independently a hydrogen atom or an alkyl group, an alkylol group, an alkoxyalkyl group, or an acetyl group having a carbon number of 1 or more and 3 or less, where R² and R³ are not simultaneously a hydrogen atom.

6. The use according to any one of claims 1 to 5, wherein the abrasive grains are silica particles.

## Patentansprüche

1. Verwendung einer Zusammensetzung zum Polieren von Einkristall-Siliziumwafern, wobei die Zusammensetzung in Gegenwart von Schleifkörnern verwendet wird, wobei die Zusammensetzung umfasst:
einen Siliziumwafer-Polierbeschleuniger;
ein Amidogruppen enthaltendes Polymer X;
eine organische Verbindung Y ohne Amidogruppe; und
Wasser,
wobei das Amidogruppen enthaltende Polymer X an einer Hauptkette einen Baustein A aufweist, der von einem Monomer der allgemeinen Formel (1) abgeleitet ist,
wobei das Amidogruppen enthaltende Polymer X ein Molekulargewicht Mₓ von weniger als 5 × 10⁴ aufweist,
wobei das Verhältnis zwischen dem Molekulargewicht Mₓ des Amidogruppen enthaltenden Polymers X und dem Molekulargewicht M_{y} der organischen Verbindung Y den Ausdruck erfüllt: 200 ≤ M_{y} < Mₓ: 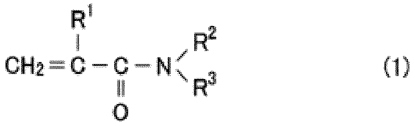 worin R¹ ein Wasserstoffatom; eine Alkylgruppe, eine Alkenylgruppe, eine Alkinylgruppe, eine Aralkylgruppe, eine Alkoxygruppe, eine Alkoxyalkylgruppe oder eine Alkylolgruppe mit einer Kohlenstoffzahl von 1 oder mehr und 6 oder weniger; eine Acetylgruppe; eine Phenylgruppe; eine Benzylgruppe; eine Chlorgruppe; eine Difluormethylgruppe; eine Trifluormethylgruppe; oder eine Cyanogruppe ist; und R² und R³ gleich oder verschieden sind und unabhängig voneinander ein Wasserstoffatom; eine Alkylgruppe, eine Alkenylgruppe, eine Alkinylgruppe, eine Aralkylgruppe, eine Alkoxygruppe, eine Alkoxyalkylgruppe, eine Alkylolgruppe oder eine Acetylgruppe mit einer Kohlenstoffzahl von 1 oder mehr und 18 oder weniger; oder eine aromatische Gruppe mit einer Kohlenstoffzahl von 6 oder mehr und 60 oder weniger sind, wobei die Gruppen außer dem Wasserstoffatom gegebenenfalls einen Substituenten aufweisen, und R² und R³ nicht gleichzeitig ein Wasserstoffatom sind.

2. Verwendung nach Anspruch 1, wobei das Verhältnis des Molekulargewichts M_{y} der organischen Verbindung Y zum Molekulargewicht Mₓ des Amidogruppen enthaltenden Polymers X (M_{y}/Mₓ) weniger als 0,5 beträgt.

3. Verwendung nach Anspruch 1 oder 2, wobei das Amidogruppen enthaltende Polymer X nichtionisch ist.

4. Verwendung nach einem der Ansprüche 1 bis 3, wobei R¹ in der allgemeinen Formel (1) ein Wasserstoffatom oder eine Methylgruppe ist.

5. Verwendung nach einem der Ansprüche 1 bis 4, wobei R² und R³ in der allgemeinen Formel (1) gleich oder verschieden sind und unabhängig voneinander ein Wasserstoffatom oder eine Alkylgruppe, eine Alkylolgruppe, eine Alkoxyalkylgruppe oder eine Acetylgruppe mit einer Kohlenstoffzahl von 1 oder mehr und 3 oder weniger sind, wobei R² und R³ nicht gleichzeitig ein Wasserstoffatom sind.

6. Verwendung nach einem der Ansprüche 1 bis 5, wobei die Schleifkörner Silicapartikel sind.

## Revendications

1. Utilisation d'une composition pour le polissage de plaquettes de silicium monocristallin, la composition étant utilisée en présence de grains abrasifs, la composition comprenant :
un accélérateur de polissage de plaquettes de silicium ;
un polymère X contenant un groupe amido ;
un composé Y organique n'ayant pas de groupe amido ; et
de l'eau,
le polymère X contenant un groupe amido ayant, sur une chaîne principale, un bloc de construction A dérivé d'un monomère représenté par la Formule Générale (1),
le polymère X contenant un groupe amido ayant un poids moléculaire Mₓ inférieur à 5 x 10⁴,
une relation entre un poids moléculaire Mₓ du polymère X contenant un groupe amido et un poids moléculaire M_{y} du composé organique Y satisfaisant à une expression : 200 ≤ M_{y} < Mₓ : 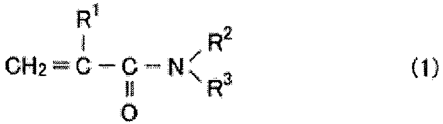 où R¹ est un atome d'hydrogène ; un groupe alkyle, un groupe alcényle, un groupe alcynyle, un groupe aralkyle, un groupe alcoxy, un groupe alcoxyalkyle, ou un groupe alkylol ayant un nombre de carbones de 1 ou plus et de 6 ou moins ; un groupe acétyle ; un groupe phényle ; un groupe benzyle ; un groupe chloro ; un groupe difluorométhyle ; un groupe trifluorométhyle ; ou un groupe cyano ; et R² et R³ sont identiques ou différents et sont indépendamment un atome d'hydrogène ; un groupe alkyle, un groupe alcényle, un groupe alcynyle, un groupe aralkyle, un groupe alcoxy, un groupe alcoxyalkyle, un groupe alkylol, ou un groupe acétyle ayant un nombre de carbones de 1 ou plus et de 18 ou moins; ou un groupe aromatique ayant un nombre de carbones de 6 ou plus et de 60 ou moins, où les groupes à l'exception de l'atome d'hydrogène ont facultativement un substituant, et R² et R³ ne sont pas simultanément un atome d'hydrogène.

2. Utilisation selon la revendication 1, dans laquelle un rapport entre le poids moléculaire M_{y} du composé organique Y et le poids moléculaire Mₓ du polymère X contenant un groupe amido (M_{y}/Mₓ) est inférieur à 0,5.

3. Utilisation selon la revendication 1 ou 2, dans laquelle le polymère X contenant un groupe amido est non-ionique.

4. Utilisation selon l'une quelconque des revendications 1 à 3, dans laquelle R¹ dans la Formule Générale (1) est un atome d'hydrogène ou un groupe méthyle.

5. Utilisation selon l'une quelconque des revendications 1 à 4, dans laquelle R² et R³ dans la Formule Générale (1) sont identiques ou différents et sont indépendamment un atome d'hydrogène ou un groupe alkyle, un groupe alkylol, un groupe alkoxyalkyle, ou un groupe acétyle ayant un nombre de carbones de 1 ou plus et de 3 ou moins, où R² et R³ ne sont pas simultanément un atome d'hydrogène.

6. Utilisation selon l'une quelconque des revendications 1 à 5, dans laquelle les grains abrasifs sont des particules de silice.
